(19) Europäisches Patentamt
European Patent Office
Office européen des brevets

(11) EP 2 596 524 B1

(12) **FASCICULE DE BREVET EUROPEEN**

(45) Date de publication et mention de la délivrance du brevet:
**21.11.2018 Bulletin 2018/47**

(21) Numéro de dépôt: **11736347.3**

(22) Date de dépôt: **21.07.2011**

(51) Int Cl.:
***H01L 21/60*** *(2006.01)* ***H01L 23/485*** *(2006.01)*
***H01L 21/98*** *(2006.01)* ***H01L 21/762*** *(2006.01)*
*H01L 21/58* *(2006.01)*

(86) Numéro de dépôt international:
**PCT/EP2011/062540**

(87) Numéro de publication internationale:
**WO 2012/010662 (26.01.2012 Gazette 2012/04)**

(54) **PROCEDE D'ASSEMBLAGE PAR COLLAGE DIRECT ENTRE DEUX ELEMENTS COMPRENANT DES PORTIONS DE CUIVRE ET DE MATERIAUX DIELECTRIQUES**

VERFAHREN FÜR DIREKTES VERKLEBEN ZWEIER ELEMENTE MIT KUPFERTEILEN UND DIELEKTRISCHEN MATERIALIEN

PROCESS FOR DIRECT BONDING TWO ELEMENTS COMPRISING COPPER PORTIONS AND DIELECTRIC MATERIALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.07.2010 FR 1055936**

(43) Date de publication de la demande:
**29.05.2013 Bulletin 2013/22**

(73) Titulaire: **Commissariat à l'Énergie Atomique et aux Énergies Alternatives**
**75015 Paris (FR)**

(72) Inventeurs:
- **DI CIOCCIO, Léa**
  **38330 Saint Ismier (FR)**
- **GUEGUEN, Pierric**
  **38130 Echirolles (FR)**

(74) Mandataire: **Ilgart, Jean-Christophe et al**
**Brevalex**
**95, rue d'Amsterdam**
**75378 Paris Cedex 8 (FR)**

(56) Documents cités:
**EP-A2- 0 700 088** **US-A1- 2004 262 772**
**US-A1- 2005 003 664** **US-A1- 2005 079 685**
**US-A1- 2005 104 216** **US-A1- 2007 232 023**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

## DOMAINE TECHNIQUE ET ART ANTÉRIEUR

La présente invention se rapporte à un procédé d'assemblage de deux éléments par collage direct entre deux surfaces comportant à la fois des portions en cuivre et des portions en matériau diélectrique, ce procédé est notamment utilisable dans la réalisation de dispositifs microélectroniques et nanoélectroniques.

L'intégration en trois dimensions dans les dispositifs microélectroniques et nanoélectroniques permet de réduire la taille des dispositifs, de réduire leur consommation électrique, d'augmenter les vitesses de transmission, les performances, la fréquence de fonctionnement...

Une intégration en trois dimensions comporte notamment les étapes de collage avec alignement des plots de connexion, d'amincissement et d'interconnexion verticale à travers l'empilement.

On utilise la technologie TSV (Through Silicon Via) qui consiste à réaliser des via de connexion à travers le silicium. Cependant pour obtenir une densité d'interconnexion élevée et pour simplifier la technologie, il est préférable d'assembler les éléments, et en particulier les connexions par un collage métal-métal directement.

Le cuivre est un des métaux particulièrement utilisés pour réaliser des plots de connexion.

Il existe différentes méthodes pour réaliser un collage direct cuivre-cuivre : par thermocompression ou sous ultravide, les surfaces ayant été activées au moyen d'un plasma argon. Ces méthodes permettent d'obtenir de bons résultats, cependant elles nécessitent soit un ultravide pour la préparation des surfaces, soit une température élevée pour réaliser le collage, soit de travailler sous une atmosphère particulière. L'application d'une pression peut endommager les dispositifs microélectroniques et nanoélectroniques.

Les surfaces à assembler peuvent être composées de portions de cuivre séparées par des portions de matériau diélectrique ou de portions de cuivre délimitées au sein d'une surface de matériau semi-conducteur par des zones diélectriques d'isolation électrique.

Lors de la mise en contact des plots de cuivre, les faces libres des plots de cuivre d'une surface sont alignées avec les faces libres des plots de cuivre de l'autre surface. Or cet alignement n'est généralement pas parfait, une partie de la surface des plots peut se trouver alors en contact avec le matériau diélectrique. Or ce contact peut provoquer une diffusion du cuivre d'une surface dans le matériau diélectrique de l'autre surface, ce qui peut être problématique pour les transistors des dispositifs microélectroniques et nanoélectroniques et générer des courants de fuite rédhibitoires.

Le document US2004/262772 décrit un procédé de collage entre deux éléments munis de plots en cuivre recouverts par une barrière de diffusion. Le document EP 0700088 décrit un procédé de collage direct entre les zones diélectriques et entre les zones en cuivre de deux surfaces à coller.

C'est par conséquent un but de la présente invention d'offrir un nouveau procédé de réalisation d'une structure comportant des surfaces mixtes en regard, comportant du cuivre et d'autres matériaux, par exemple des matériaux diélectriques, dans laquelle la diffusion du cuivre dans les autres matériaux de la face en regard assemblée est limitée, voire empêchée.

## EXPOSÉ DE L'INVENTION

Le but précédemment énoncé est atteint par un procédé de collage direct, lors duquel, préalablement à la mise en contact des éléments à coller, on effectue un polissage des surfaces à mettre en contact de sorte à atteindre une très faible rugosité, et on réalise sur les zones de cuivre une barrière de diffusion auto-alignée électriquement conductrice.

On peut effectuer préalablement à la mise en contact une réactivation des surfaces, par exemple par plasma.

En d'autres termes, on réalise des assemblages d'éléments comportant des portions de cuivre munies de barrières de diffusion auto-alignées par collage direct. Ces barrières ne gêne ni le collage, ni le niveau de conduction électrique au niveau des zones de cuivre en regard assemblées.

Dans un mode avantageux, la rugosité des surfaces au niveau des zones venant au contact lors de la mise en contact des surfaces en vue de leur collage est de préférence inférieure à 1 nm RMS, et de manière encore préférée inférieure à 0,5 nm RMS.

Une telle valeur de rugosité peut être obtenue par polissage mécano-chimique.

L'épaisseur de la barrière de diffusion auto-alignée déposée sur le cuivre peut être au plus égale à la profondeur des cuvettes, appelées "dishing", formées à la surface des portions de cuivre lors du polissage; la profondeur des cuvettes est par exemple de l'ordre de 20 nm. Dans une variante avantageuse, la barrière de diffusion auto-alignée peut être en retrait par apport au reste de la surface.

Ainsi en cas de retrait des deuxièmes barrières de diffusion par rapport à la surface des éléments, lors de la mise en contact des éléments, le collage a lieu au niveau des zones diélectriques, un traitement thermique ultérieur permet le collage au niveau des zones de cuivre. Dans le cas où les deuxièmes barrières de diffusions sont en saillie, lors de la mise en contact, le collage a lieu au niveau des plots de cuivre, et un traitement thermique permet le collage

au niveau des zones diélectriques. Enfin, si la surface est suffisamment plane, i.e. la surfaces des zones diélectriques et la surface des zones de cuivre sont sensiblement dans un même plan, le collage a lieu directement sur la totalité des surfaces au moment de la mise en contact. Le traitement thermique qui a lieu pendant ou après la mise en contact permet dans ce cas de renforcer l'énergie de collage.

La présente invention, telle que définie dans les revendications ci-jointes, a alors pour objet un procédé d'assemblage par collage direct d'un premier et d'un deuxième élément munis chacun d'une surface comportant des portions de cuivre séparées par au moins un matériau diélectrique, ledit procédé comportant :

A) au moins une étape de polissage desdites surfaces des premier et deuxième éléments de sorte que les surfaces à assembler soient compatibles avec un assemblage par collage, en termes de rugosité et d'hydrophilie,
B) une étape de formation d'une barrière de diffusion sélectivement sur les portions de cuivre des premier et deuxième éléments de sorte que la surface de la barrière de diffusion des premier et deuxième éléments affleure ladite surface avec un écart inférieur à 5 nanomètres, la barrière de diffusion étant un alliage de cobalt ou de nickel et,
C) une étape de mise en contact des deux surfaces de sorte que les portions de cuivre d'une surface recouvrent au moins en partie les portions de cuivre de l'autre surface formant des zones de recouvrement, et de sorte qu'un collage direct soit obtenu entre les surfaces au niveau des zones diélectriques et au niveau des zones en cuivre.

L'alliage de la barrière de diffusion est par exemple du CoWB, CoWP ou du CoWBP.

De préférence, l'étape A) comporte :

a) au moins une étape de polissage des surfaces de sorte à obtenir une rugosité inférieure à 1 nm RMS, et des surfaces hydrophiles,
b) au moins une étape de nettoyage des dites surfaces afin de supprimer la présence de particules dues au polissage et la majeure partie des inhibiteurs de corrosion.

Avantageusement l'étape C) comprend préalablement à la mise en contact des surfaces, une étape de réactivation des surfaces de sorte qu'elles présentent un caractère hydrophile.

La réactivation des surfaces est obtenue préférentiellement par plasma, par exemple plasma $He/H_2$ ou $N_2/H_2$ ou $O_2/H_2$.

De manière avantageuse, la mise en contact de l'étape C) a lieu à température ambiante et à pression atmosphérique.

Dans un exemple de réalisation, le collage direct de l'étape C) entre les portions de cuivre au niveau des zones de recouvrement a lieu à température ambiante et à pression atmosphérique.

Dans un autre exemple de réalisation, le collage direct au niveau des zones de recouvrement entre les portions de cuivre est obtenu après traitement thermique.

Dans un exemple de réalisation, l'étape B) comporte les étapes :

b1) nettoyage des surfaces des éléments et un retrait de l'oxyde natif de cuivre,
b2) dépôt d'un catalyseur sur la surfaces, par exemple du palladium, réagissant avec le cuivre,
b3) croissance électrolytique de la barrière de diffusion sur une épaisseur donnée.

Le matériau de la barrière de diffusion peut alors être un alliage ternaire à base de cobalt.

Dans un autre exemple de réalisation, l'étape B) comporte les étapes :

b1') nettoyage des surfaces des éléments et un retrait de l'oxyde natif de cuivre,
b2') croissance de ladite barrière de diffusion sur les portions de cuivre au moyen d'une solution auto-activée.

Partant d'éléments comportant un substrat, une couche de matériau diélectrique déposée sur le substrat, ladite couche en matériau diélectrique étant munie de gravures, une couche de cuivre recouvrant la couche en matériau diélectrique et remplissant les gravures de la couche en matériau diélectrique, l'étape A) de polissage peut comporter les sous étapes suivantes :

a1) polissage mécano-chimique de la couche de cuivre de chaque élément avec une solution chimique aplanissante jusqu'à obtention d'une surface de cuivre sensiblement plane,
a2) polissage mécano-chimique de la couche de cuivre restante avec une solution chimique non aplanissante sélective jusqu'à retrait total du cuivre sur la couche en matériau diélectrique en dehors de gravures.

Selon une autre caractéristique, dans le cas où les éléments comportent une autre barrière de diffusion entre

la couche en matériau diélectrique et la couche de cuivre, lors de l'étape a2), le polissage de la couche de cuivre peut avoir lieu jusqu'à sa disparition sur l'autre barrière de diffusion en dehors des gravures.

Selon une autre caractéristique, le cuivre peut par exemple être en retrait de la surface du matériau diélectrique. La croissance de la barrière de diffusion peut par exemple être est stoppée lorsque son épaisseur est au plus égale à la distance entre la surface de la couche en matériau diélectrique et la surface de cuivre en retrait.

## BRÈVE DESCRIPTION DES DESSINS

La présente invention sera mieux comprise à l'aide de la description qui va suivre et des dessins en annexes sur lesquels :

- les figures 1A à 1D sont des représentations schématiques de différentes étapes d'un exemple de procédé de collage selon la présente invention ;
- les figures 2A et 2B sont des représentations schématiques de l'étape de polissage ;
- les figures 3A à 3D sont des représentations schématiques d'un exemple de dépôt de barrières de diffusion auto-alignées ;
- la figure 4 est une vue en coupe d'une variante d'assemblage obtenu selon le procédé de la présente invention.

## EXPOSÉ DÉTAILLÉ DE MODES DE RÉALISATION PARTICULIERS

Le procédé selon la présente invention consiste à réaliser un collage direct entre deux surfaces comprenant des portions de cuivre et des portions de matériau diélectrique, par exemple du $SiO_2$. En variante, il est possible, que l'une au moins des surfaces comprenne des portions de cuivre délimitées par des portions de matériau diélectrique au sein de portions d'un troisième matériau, par exemple un matériau semi-conducteur.

L'assemblage de deux éléments dont les surfaces à mettre en contact n'ont pas la même structure ne sort pas du cadre de la présente invention.

Le collage direct, parfois appelé collage moléculaire, est compris comme la mise en contact de deux surfaces sensiblement planes au cours de laquelle ces deux surfaces sensiblement planes adhèrent l'une à l'autre sans ajout de matière adhésive.

Dans la description qui va suivre, le procédé selon la présente invention sera décrit dans le cadre du collage de deux éléments destinés aux réalisations de dispositifs microélectroniques ou nanoélectroniques, plus particulièrement pour réaliser la connexion de plots de connexion en cuivre, mais le procédé selon la présente invention s'applique au collage de portions de cuivre qui ne sont pas nécessairement des plots de connexion. Il peut s'agir par exemple de vias traversants comme cela est schématisé sur la figure 4. En outre, le procédé selon l'invention peut être mis en oeuvre dans tous les domaines dans lesquels on souhaite assembler des surfaces mixtes comportant du cuivre tout en évitant une diffusion non souhaitée du cuivre.

Sur la figure 1D, on peut voir représenté schématiquement un premier I et un deuxième II élément assemblés par le procédé selon la présente invention.

Le premier élément I comporte un substrat 2, par exemple en silicium, une couche de matériau diélectrique 4, par exemple en $SiO_2$, des plots en cuivre 6 dans des zones gravées du matériau diélectrique 4, une première barrière de diffusion 8 entre la couche de matériau diélectrique 4 et les plots en cuivre 6 et une couche 10 sur chacun des plots 6 formant une deuxième barrière de diffusion du cuivre.

La première barrière de diffusion 8 est par exemple en TiN ou plus généralement en un métal dans lequel la diffusion du cuivre est faible et qui présente une bonne adhérence sur le diélectrique sur lequel il est déposé. Le platine ou le tungstène par exemple peut être utilisé comme barrière de diffusion. Il peut s'agir également d'un empilement de plusieurs couches, par exemple Ti/TiN ou Ta/TaN.

Le matériau diélectrique est avantageusement du $SiO_2$ mais il pourrait s'agir plus généralement d'un oxyde ou d'un nitrure, tel que du SiOCH, SiN ou SiCN par exemple, ou d'un polymère.

Le deuxième élément II, qui est représenté sur la figure 1D est similaire. Il comporte également des plots en cuivre 106 dans une couche en matériau diélectrique 104, les plots 106 étant recouverts d'une deuxième barrière de diffusion du cuivre 110. Une première barrière de diffusion 108 est également présente entre les plots 106 et la couche en matériau diélectrique 104.

En variante, comme cela est représenté sur la figure 4, les éléments I'' et/ou II'' pourraient comporter des plots 206 traversant l'intégralité du substrat 202 formant des vias traversants (TSV : "Through Silicon Via" en anglais), en étant isolés électriquement de ce substrat par une zone diélectrique 204 entourant les plots 206. Une première barrière de diffusion 208 pourrait être prévue de la même façon entre le plot 206 et cette zone diélectrique 204. Une deuxième barrière de diffusion 210 est également déposée sur les plots 206.

Les deuxièmes barrières de diffusion 10, 110 sont dites auto-alignées, c'est-à-dire qu'elles sont précisément

alignées avec les zones de cuivre d'intérêt sans qu'il soit nécessaire de se préoccuper de cet alignement. L'alignement est obtenu du fait même du mode de dépôt choisi pour ces barrières, à savoir une croissance sélective de ces barrières sur le cuivre. Les barrières de diffusion 8, 108 sont, quant à elles, avantageusement déposées sur toute la surface du matériau diélectrique avant le dépôt du cuivre. Des exemples de modes de dépôt de la deuxième couche de diffusion seront décrits dans la suite de la description.

Le procédé selon la présente invention a pour objet d'assembler ces deux éléments I, II, de sorte que les plots 6 du premier élément I soient au moins en partie en contact avec les plots 106 du deuxième élément II, ce qui assure une conduction électrique satisfaisante entre les deux éléments I, II.

Le procédé selon la présente invention, telle que définie dans les revendications ci-jointes, comporte :

- au moins une étape A) de polissage des surfaces à mettre en contact de sorte que la surface de la deuxième barrière de diffusion
- une étape B) de formation d'une barrière de diffusion sur la surface libre des plots de cuivre,
- une étape C) de mise en contact des surfaces induisant un collage direct hydrophile des deux éléments par lesdites surfaces. Cette étape peut avantageusement avoir lieu à température ambiante et à pression atmosphérique.

L'étape A) comprenant :

a) une étape de polissage des éléments I, II de sorte à libérer des surfaces munies de plots 6, 106, et de sorte que les surfaces des deux éléments présentent au niveau des portions mises en contact une rugosité et une hydrophilie permettant un collage direct au niveau de ces zones en contact dès leur mise en contact.
De préférence, la rugosité est inférieure à 1 nm RMS, de manière encore préférée inférieure ou égale à 0,5 nm RMS. Cette étape permet éventuellement de libérer également des surfaces formées de matériau diélectrique 4,
b) de préférence une étape de nettoyage des dites surfaces afin de supprimer la présence de particules dues au polissage. A la fin de cette étape, les faces présentent un caractère hydrophile.

Avantageusement une étape de réactivation d'au moins les portions de matériau diélectrique peut être prévue avant l'étape de mise en contact de sorte que les surfaces présentent un caractère hydrophile.

Nous allons maintenant décrire en détail le procédé de collage selon la présente invention permettant d'obtenir l'assemblage de la figure 1D.

Les deux éléments I et II sont réalisés suivant les mêmes étapes.

Sur un substrat 2 comportant en surface une couche diélectrique 4, on grave localement la couche diélectrique 4 sur une partie de son épaisseur aux endroits 14 destinés à recevoir les plots de cuivre 6. Une couche 8 formant barrière de diffusion est ensuite déposée de façon conforme. Cette couche peut avoir une large gamme d'épaisseur (typiquement de 5 nm à 100 nm).

Sur la figure 1A, on peut voir un élément I' après dépôt sur cet empilement d'une couche de cuivre 12 pour réaliser les plots 6.

La couche de cuivre 12 est déposée sur la première couche 8 formant barrière de diffusion.

Lors d'une étape suivante représentée sur la figure 1B, on effectue un polissage de la couche de cuivre 12 jusqu'à mettre à nu le matériau diélectrique 4 hors des zones gravées 14.

Ce polissage a lieu en deux étapes représentées sur les figures 2A et 2B. Une première étape consiste à polir la couche de cuivre 12 jusqu'à découvrir la première barrière de diffusion (figure 2A), puis dans une étape suivante à polir la première couche de diffusion 8 jusqu'à découvrir le matériau diélectrique 4 (figure 2B), le polissage de cette étape est avantageusement tel que la surface du matériau diélectrique 4 et celle du cuivre soit sensiblement au même niveau. Un écart de quelques nanomètres, typiquement 5 nm, qui est fonction de la taille et de la densité des plots de cuivre peut être admis et rester compatible avec le collage direct. La surface des plots peut donc soit être en retrait de la surface du matériau diélectrique, soit être en saillie de la surface du matériau diélectrique.

Avantageusement, le polissage est tel également que la rugosité de la surface du matériau diélectrique 4 et du cuivre est inférieure à 1 nm RMS ("Root Mean Square value" en anglais), avantageusement inférieur" à 0,5 nm RMS.

L'étape de polissage permettant de passer de la structure de la figure 1A à la structure de la figure 2B est par exemple, basé sur un polissage mécano-chimique ou CMP (« Chemical Mechanical Polishing » en anglais).

Lors d'une première étape de polissage a1) on aplanit la couche de cuivre 12 pour éliminer les reliefs obtenus après dépôt de la couche de cuivre 12 dus notamment aux zones gravées 1 4et ainsi obtenir une couche 12 sensiblement plane. Pour cela, on effectue un polissage mécano-chimique avec un produit chimique aplanissant. Un produit chimique ou slurry est dit « aplanissant », lorsqu'il permet de réduire les marches présentes après dépôt de matière sur une structure. On appelle "slurry", des particules en suspension dans une solution chimique acide ou basique.

Ensuite, lors d'une étape a2) on effectue un polissage destiné à retirer la couche de cuivre située sur la première barrière de diffusion 8 en dehors des zones gravées 14 et ainsi mettre à nu cette première barrière de diffusion 8 dans

ces zones. Pour cela, on effectue un polissage mécano-chimique avec un slurry non aplanissant et sélectif sur la barrière de diffusion, i.e. qu'il attaque le cuivre et n'attaque pas la barrière de diffusion. Les surfaces libres des plots en cuivre ont alors un profil en cuvette 18, appelé également "dishing". Par exemple, la profondeur de ces cuvettes est de l'ordre de 20 nm.

La profondeur des cuvettes peut être contrôlée par les paramètres de polissage, par exemple par la pression, le temps de polissage et le choix du ou des slurries utilisés.

Lors d'une étape suivante a3), on réalise le retrait de la barrière de diffusion et éventuellement d'une partie du matériau diélectrique.

Nous allons maintenant décrire plus en détail les moyens qui peuvent être mis en oeuvre pour effectuer le polissage mécano-chimique pour la réalisation de la présente invention.

La surface de l'élément I' à polir est frottée sur un tissu appelé "pad" composé de polyuréthane poreux viscoélastique et dont les propriétés (dureté, compressibilité, forme et dimension des pores ainsi que des motifs...) dépendent de la nature du matériau à polir. Le ou les matériaux à la surface de l'élément 2 est (sont) arraché(s) par réaction chimique et action mécanique à l'aide du tissu et/ou d'une solution contenant des particules appelée "slurry" (particules en suspension dans une solution chimique acide ou basique). Ces slurries peuvent être composés de particules de tailles nanométriques dans une solution liquide (solution colloïdale, micelles, Langmuir-Blodget, etc.).

Le polissage est obtenu par la combinaison de plusieurs actions :

- une action mécanique obtenue par le frottement du tissu et/ou des particules du slurry sur la surface. La vitesse d'enlèvement du matériau a été modélisée par Preston selon l'équation suivante :

$$RR = K_p \times P \times V \quad [1]$$

avec :

RR (Removal Rate) : taux d'enlèvement en un point donné (en nm/min),
$K_p$ = Constante de Preston prenant en compte les caractéristiques du matériau, du tissu, du type d'abrasif, de la température...
P = Pression appliquée (en Newton),
V = Vitesse linéaire d'un point de la plaque par rapport au tissu (en m/s),

- une action chimique ; lors du polissage, on souhaite à la fois polir du cuivre et le matériau diélectrique. Les slurries sont donc adaptés pour avoir une action chimique sur le cuivre et sur le matériau diélectrique. Concernant le cuivre, l'action chimique provient généralement d'une attaque par un acide et/ou d'un oxydant permettant de réagir avec la surface à polir.

Généralement, un slurry est constitué par la présence d'agent chimique d'attaque des métaux, d'un oxydant (généralement $H_2O_2$), d'un agent stabilisateur du pH ajouté à la solution acide ou basique du slurry et d'un inhibiteur de corrosion. La solution chimique va passiver (K1) le matériau en formant à sa surface un oxyde métallique qui sera enlevé mécaniquement (K2) par le tissu et par les éventuelles particules du slurry.

La solution chimique va alors formée du $CuO_X$.

$$Cu + OX \xrightarrow{k_1} CuOX^* \xrightarrow{k_2} CuOX$$

Cette réaction chimique facilite et accélère le mécanisme de polissage. D'autres réactions chimiques peuvent être engendrées par la formation de cations métalliques cuivre/cuivre$^+$ ou cuivre/$Cu^{2+}$ solubles et retirés de la surface à polir par le tissu et ou les particules du slurry.

Pour le matériau diélectrique, les slurries utilisés généralement sont des solutions aqueuses.

L'eau a un intérêt pour le polissage de diélectrique, par exemple d'un oxyde de silicium. Deux réactions chimiques interviennent.

Tout d'abord, l'eau pénètre sous l'effet de la pression et casse certaines liaisons Si - O de l'oxyde de silicium pour former une surface hydratée.

La séparation des liaisons (Si-O-Si) est contrôlée par la diffusion de l'eau dans la silice. Le polissage se réalise lorsque la réaction d'hydratation réversible (polymérisation) suivante :

$$(SiO_2)_X + 2H_2O \leftrightarrow (SiO_2)_{X-1} + Si(OH)_4$$

peut se produire dans le sens inverse, c'est-à-dire dans de le sens de l'hydratation (dépolymérisation), comme cela est décrit notamment dans l'ouvrage *"Handbook of Semiconductor Interconnection Technology"* par GC Schwarz.

Le mouvement du tissu par rapport à la plaque de silicium permet alors d'arracher les particules de slurry de la surface emportant ainsi des atomes du matériau superficiel.

Afin d'effectuer une attaque chimique à la fois du cuivre et du matériau diélectrique, on peut utiliser une solution aqueuse obtenue par solubilisation dans de l'eau désionisée :

- d'un ou deux agents complexant ou d'attaque chimique des métaux et des éventuels composés métalliques (glycine, NH3, EDTA, etc.) qui permet d'augmenter la vitesse de polissage du cuivre,
- d'un inhibiteur de corrosion du cuivre (benzotriazole BTA, triazole TA...), agent passivant le film de cuivre qui réduit la vitesse de polissage spécifiquement dans les zones basses à aplanir (souvent deux inhibiteurs sont utilisés),
- d'un surfactant pour stabiliser le pH, améliorer la sélectivité de polissage du cuivre vis-à-vis des autres matériaux utilisés...
- d'un agent oxydant ($H_2O_2$, $KIO_3$, hydroxylamine, etc.) qui suivant le pH et/ou sa concentration peut former soit une passivation du cuivre par un oxyde ou hydroxyde de cuivre insoluble, soit une corrosion par un cation métallique soluble dans la solution aqueuse,
- de particules colloïdales anionique ou cationique, présentant un pH compris entre 1 et 12 sont avantageusement ajoutées pour obtenir une suspension stable de particules. Les particules peuvent être pures comme la silice, du carbone, l'oxyde de cérium, l'alumine ou des polymères. Les tailles des particules élémentaires seront déterminées par la méthode de mise en solution choisie. Elles pourront varier de 3nm à 300nm. Le pourcentage massique de particules dans la solution aqueuse pourra être compris entre quelques ppm et 50 %.

A titre d'exemple, les solutions aqueuses suivantes peuvent être utilisées :

- pour l'étape a1), on peut utiliser le slurry EPL2361 vendu par la société CMC (Cabot Mircoelectronic Corporation), ou CoppeReady®CU3900 de DANM (Dupont Air Product Nanomaterials L.L.C),
- pour l'étape a2), on peut utiliser le slurry DP510 de DANM ou RL3000 de Rohm & Haas, ou HS-C930-3 de Hitachi ou C7092 de CMC,
- pour l'étape a3), on peut utiliser le slurry CuS-1351 de Rohm & Haas, ou B8500 de CMC, ou DP6545 de DANM, ou T815 de Hitachi, ou FCB-837 de Fujimi corporation.

Les caractéristiques des tissus de polissage utilisés dépendent notamment des dimensions des cavités creusées dans un matériau isolant et remplies de cuivre avec ou sans barrière de diffusion ou couche d'adhésion.

A titre d'exemple, pour des cavités d'une largeur supérieure à 10 $\mu$m, on choisit des tissus dits d'aplanissements en polyuréthane avec une dureté classée en « shore D » de 50 à 70, d'une densité de 60 à 90 mg/cm$^3$, et d'une compressibilité inférieure à 4 %, par exemple le IC1000 de la société Rohm & Haas, ou le D100 de la société CMC.

Pour des cavités inférieures à 10 $\mu$m, on peut choisir par exemple des tissus dits médiums, avec une dureté classée en « shore A » de 50 à 70, d'une densité de 20 à 40 mg/cm$^3$, et d'une compressibilité entre 10 et 25 %. Pour cette application, par exemple le Suba IV de la société Rohm & Haas.

Pour des cavités de l'ordre du micromètre, certains matériaux ductiles risquant d'être rayés par les particules, des tissus de polissage dits de finitions sont préférés, avec une dureté classée en « shore A » de 50 à 80, d'une densité de <20 mg/cm$^3$, et d'une compressibilité >30 %, par exemple le POLITEX® de la société Rohm & Haas, ou des tissus de la marque Fujibo®.

Les éléments sont par exemple traités sur des polisseuses classiques par exemples de types Mirra ou Reflexion de Applied Materials USA, Megapol M550 de Alpsitec France ou FREX de Ebara Japon.

Les paramètres de polissage sont la pression d'appui exercée sur le substrat comprise entre 0,02 daN/cm$^2$ à 1 daN/cm$^2$, la vitesse d'un point du substrat par rapport à un point du tissu est comprise entre 0,1 m/s à 3 m/s, le débit de la solution aqueuse entre 5 et 300ml pour des substrats variant de 1 à 450 mm, la température étant comprise entre 2 et 70°C.

Préférentiellement les conditions pour les applications précitées sont de 0,1 daN/cm$^2$, avec une vitesse de 1 m/s, un débit de solution aqueuse de 150ml pour des substrats de 200mm à une température de 52°C.

Après l'étape de polissage mécano-chimique, une étape de nettoyage est en général prévue par exemple par brossage des plaques sous chimie neutre (i.e. en présence d'eau) ou alcaline, pour notamment éliminer les résidus de polissage.

Lors d'une étape suivante représentée sur la figure 1C, on effectue le dépôt de la deuxième barrière de diffusion 10 sur les plots de cuivre 6.

L'épaisseur de la deuxième barrière de diffusion 10 peut être sensiblement égale à la profondeur des cuvettes formées à la surface des plots 6.

De manière avantageuse, la surface de la deuxième de diffusion 10 est en retrait par rapport à le reste de la surface à assembler en restant compatible avec l'étape de collage direct. Ce retrait est inférieur à 5 nm.

Le cas de figure où le la barrière de diffusion serait en protubérance par rapport au reste de la surface de moins de 5 nm, est admissible et reste compatible avec l'étape de collage direct subséquent.

Sur la figure 1C, la surface libre de la deuxième barrière de diffusion 10 affleure la surface libre de la couche en matériau diélectrique 4.

Sur les figures 3A à 3D, on peut voir représenté schématiquement un exemple de procédé de réalisation de la deuxième barrière de diffusion 10.

Lors d'une première étape (figure 3A), on effectue un nettoyage de la surface de l'élément de la figure 2B et un retrait de l'oxyde natif de cuivre au moyen d'une solution de rinçage. On peut effectuer ensuite un séchage, par exemple sous flux d'azote.

Lors d'une étape suivante, on vaporise une solution contenant un catalyseur, par exemple du palladium ou du bore, à la surface de l'élément (figure 3B). Ce catalyseur réagit avec le cuivre. On peut effectuer ensuite un rinçage pour retirer l'excès de catalyseur n'ayant pas réagi. Le catalyseur ayant réagi forme des îlots 16 sur les plots de cuivre 6.

Lors d'une étape suivante, on fait croître la barrière de diffusion sur les plots 6, les îlots 16 servant de catalyseur pour ce dépôt. Il s'agit par exemple d'une croissance auto-catalytique représentée sur la figure 3C. L'épaisseur de la deuxième barrière de diffusion 10 est contrôlée par le temps. Par exemple, la croissance est réalisée par électrolyse en solution.

Le matériau de la deuxième barrière de diffusion est un alliage à base de cobalt ou de nickel, par exemple l'alliage CoWP.

L'arrêt de la croissance de la deuxième barrière de diffusion 10 est obtenu par exemple par rinçage suivi d'un séchage.

En variante, on peut utiliser une solution auto-activée, i.e. contenant le catalyseur en solution, l'étape de dépôt du catalyseur n'est alors dans ce cas pas nécessaire. Le matériau de la deuxième barrière de diffusion peut être dans ce cas par exemple l'alliage CoWB ou CoWPB si la solution utilisée est du DMAB (Dimethylaminoborane).

La deuxième barrière de diffusion 10 est avantageusement réalisée en alliages binaires ou ternaires à base de cobalt ou de nickel. Ces alliages présentent offrent des propriétés de barrières contre la diffusion du cuivre.

En outre, ils présentent les avantages d'avoir une croissance localisée et sélective sur les lignes de cuivre indépendamment de la microstructure de cuivre et de sa cristallinité, de présenter une meilleure adhésion avec le cuivre qu'une barrière diélectrique, d'être conducteur et d'améliorer les performances de fiabilité.

Par exemple, le matériau pour la deuxième barrière de diffusion peut être choisi parmi la liste suivante : CoWB, CoWP, NiP, NiWB, NiW, NiB, NiReP, NiMoP, NiWP, CoWPB, CoWBO, CoMoPO.

Le procédé de dépôt de ces matériaux est similaire à celui décrit précédemment.

De préférence, on choisit des matériaux offrant une faible résistivité, par exemple inférieure à 1 Ω•cm, et/ou une température de dépôt relativement basse, typiquement inférieure à 400°C, voire 200°C, et/ou une grande stabilité en température. De préférence, il s'agit de CoWP qui peut être déposé à 100°C. Celui-ci reste stable jusque 400°C et présente une résistivité inférieure à 40 μΩ•cm.

Le dépôt de la barrière de diffusion 10 sur le cuivre ne provoque pas d'augmentation de la rugosité de la surface. Par conséquent, la surface libre de la deuxième barrière de diffusion présente une rugosité inférieure à 1 nm RMS.

Lorsque les deux éléments sont prêts, on effectue si cela se révèle nécessaire une réactivation des surfaces à mettre en contact, en particulier les surfaces des couches de matériau diélectrique pour les rendre compatibles pour le collage direct, i.e. pour rendre les surfaces hydrophiles.

Dans la présente demande, une surface est considérée comme hydrophile si l'angle de contact est compris entre 0° et 20°, de préférence celui-ci est le plus faible possible.

La réactivation peut être obtenue par plasma, par exemple plasma $He/H_2$ ou $N_2/H_2$ ou $O_2/H_2$. La réactivation plasma présente l'avantage de ne pas modifier la rugosité des surfaces réactivées.

A titre d'exemple, le traitement plasma peut être réalisé au moyen de l'appareil Endura 5500B® par exemple dans les conditions suivantes : pendant 60 s sous une puissance de 450 W, sous une pression de 80 mTorr à température ambiante avec le gaz $He/H_2$

En variante, on peut envisager une réactivation chimique avec par exemple une chimie HF ou $H_2SO_4$ suivi d'une étape de nettoyage.

Les deux surfaces sont ensuite mises face à face (figure 1D), les plots de cuivre 6 recouverts de la deuxième barrière de diffusion à base d'alliage de cobalt ou de nickel 10 sont sensiblement mis en regard avec les plots de cuivre 106 recouverts de la deuxième barrière de diffusion 110 et les surfaces sont mises en contact. Les zones venant au contact adhèrent alors par collage direct hydrophile, ce collage direct peut être obtenu à température ambiante et à pression atmosphérique. La seconde barrière de diffusion en alliage de cobalt ou de nickel est compatible avec un

collage, et également avec un collage direct.

Lorsque les surfaces des éléments à mettre en contact sont suffisamment planes, i.e. la surface des zones diélectriques et la surface des zones de cuivre sont sensiblement dans un même plan, le collage a lieu directement sur la totalité des surfaces au moment de la mise en contact.

Un traitement thermique à une température d'au moins 200°C, par exemple 400°C peut avoir lieu pendant ou après la mise en contact permet dans ce cas de renforcer l'énergie de collage.

Dans le cas avantageux où la deuxième barrière de diffusion est en retrait, les surfaces mises en contact à l'étape c) commencent par adhérer au niveau des zones diélectriques, avantageusement à température et pression ambiantes, puis un traitement thermique est réalisé à une température d'au moins 200°C, par exemple 400°C pour permettre la dilatation du cuivre, la mise en contact du matériau des barrières de diffusion et enfin le collage au niveau de ces zones de cuivre.

Typiquement, pour des plots de cuivre de 10 $\mu$m de côté et 500 nm d'épaisseur un retrait de l'ordre de 5 à 10 nm pourra être résorbé lors du traitement thermique. La couche formant la deuxième barrière de diffusion aura typiquement une épaisseur de 1 à 20 nm.

Le fait d'avoir une zone de collage au niveau du cuivre en retrait offre l'avantage que le collage a lieu uniquement au niveau des zones diélectriques au moment de la mise en contact. Le collage s'il est réalisé à faible température typiquement à l'ambiante, est donc faible. Il est alors possible après cette étape de mise en contact, et avant l'étape de traitement thermique, de vérifier par exemple par inspection infrarouge au niveau de croix d'alignement conçues à cet effet l'alignement des deux éléments et si besoin de décoller les deux éléments qui adhérent faiblement au niveau des zones diélectriques et de les recoller de façon plus satisfaisante avant de procéder au traitement thermique qui va à la fois consolider le collage au niveau des zones diélectriques mais également permettre la dilatation du cuivre et le collage au niveau des zones de cuivre. Lorsque le collage est réalisé en premier au niveau des zones métalliques, les surfaces adhérent fortement et ne peuvent être facilement décollées.

La résorption du retrait des plots de cuivre pat traitement thermique dépend entre autres des dimensions de plots de cuivre, et des conditions de température du traitement thermique. L'homme du métier adaptera donc les valeurs du retrait des plots avant collage en fonction de ces paramètres. En outre, il est envisageable que les retraits des plots de cuivre sur les deux éléments à assembler aient des valeurs différentes.

Dans le cas où les deuxièmes barrières de diffusion sont en saillie, lors de la mise en contact le collage a lieu tout d'abord au niveau des zones de cuivre, et un traitement thermique permet le collage au niveau des zones diélectriques.

Le traitement thermique assure également d'avoir une bonne conduction électrique entre les zones de cuivre en regard.

Un traitement thermique peut être effectué dans tous les cas pour améliorer la résistance mécanique de l'assemblage.

Dans tous les cas de figures, le collage à terme a lieu sur la totalité des surfaces des deux éléments excepté les zones de chanfrein des plaques.

Dans le cas où il existe un désalignement des plots de cuivre, la diffusion du cuivre dans le matériau diélectrique est empêchée par les deuxièmes barrières de diffusion 10, 110. L'absence de diffusion du cuivre des plots 6, 106 vers la couche de matériau diélectrique 104, 4 de l'autre élément II, I respectivement est symbolisée par les flèches barrées 20.

On peut prévoir d'initier le collage en appliquant une pression ponctuelle sur le bord de l'un des deux éléments end direction de la zone de collage.

Le procédé de collage selon la présente invention permet de manière très simple de réaliser l'assemblage d'éléments comportant des plots en cuivre en évitant la diffusion du cuivre dans le matériau diélectrique. En outre, il évite de devoir recourir à des équipements lourds pour appliquer une pression et/ou le vide et/ou une température élevée.

Ce procédé est particulièrement adapté à la réalisation de dispositif microélectroniques, puisqu'il ne met pas en oeuvre des températures élevées. Il est bien entendu cependant qu'il ne se limite pas à une telle application, et que le procédé selon l'invention peut mettre en oeuvre lors des recuits des températures supérieures à 400°C dans d'autres domaines d'application, la température de 400°C étant la température maximale communément admise pour des procédés en face arrière de la microélectronique impliquant notamment des interconnexions via des lignes de cuivre.

## Revendications

1. Procédé d'assemblage par collage direct d'un premier(I) et d'un deuxième (II) élément munis chacun d'une surface comportant des portions de cuivre (6, 106) séparées par au moins un matériau diélectrique (4, 104), ledit procédé comportant :

   A) au moins une étape de polissage desdites surfaces des premier et deuxième éléments de sorte que les

surfaces à assembler soient compatibles avec un assemblage par collage, en termes de rugosité et d'hydrophilie,
B) une étape de formation d'une barrière de diffusion (10, 110) sélectivement sur les portions de cuivre (6, 106) des premier et deuxième éléments de sorte que la surface de la barrière de diffusion des premier et deuxième éléments affleure le reste de la surface à assembler avec un écart inférieur à 5 nanomètres, la barrière de diffusion étant un alliage de cobalt ou de nickel et,
C) une étape de mise en contact des deux surfaces de sorte que les portions de cuivre (6, 106) d'une surface recouvrent au moins en partie les portions de cuivre (106, 6) de l'autre surface formant des zones de recouvrement, et de sorte qu'un collage direct soit obtenu entre les surfaces au niveau des zones diélectriques et au niveau des zones en cuivre.

**2.** Procédé d'assemblage par collage direct selon la revendication 1, dans lequel l'étape B) de formation d'une barrière de diffusion (110, 110) sélectivement sur les portions de cuivre est exécutée de manière à ne pas provoquer d'augmentation de rugosité de la surface libre à assembler.

**3.** Procédé d'assemblage par collage direct selon la revendication 2, dans lequel ladite étape A) comporte :

a) au moins une étape de polissage des surfaces de sorte à obtenir une rugosité inférieure à 1 nm RMS, et des surfaces hydrophiles,
b) au moins une étape de nettoyage des dites surfaces afin de supprimer la présence de particules dues au polissage et la majeure partie des inhibiteurs de corrosion.

**4.** Procédé d'assemblage par collage direct selon l'une des revendications 1 à 3, dans lequel l'étape C) comprend préalablement à la mise en contact des surfaces, une étape de réactivation des surfaces de sorte qu'elles présentent un caractère hydrophile.

**5.** Procédé d'assemblage par de collage direct selon l'une des revendications 1 ou 4, dans lequel la mise en contact de l'étape C) a lieu à température ambiante et à pression atmosphérique.

**6.** Procédé d'assemblage par de collage direct selon la revendication 5, dans lequel le collage direct de l'étape C) entre les portions de cuivre au niveau des zones de recouvrement a lieu à température ambiante et à pression atmosphérique.

**7.** Procédé d'assemblage par collage direct selon l'une des revendications 1 à 5, dans lequel le collage direct au niveau des zones de recouvrement entre les portions de cuivre est obtenu après traitement thermique.

**8.** Procédé d'assemblage par collage direct selon l'une des revendications 1 à 7 en combinaison avec la revendication 4, dans lequel la réactivation des surfaces est obtenue par plasma, par exemple plasma $He/H_2$ ou $N_2/H_2$ ou $O_2/H_2$.

**9.** Procédé d'assemblage par collage direct selon l'une des revendications 1 à 8, dans lequel l'étape B) comporte les étapes :

b1) nettoyage des surfaces des éléments et un retrait de l'oxyde natif de cuivre,
b2) dépôt d'un catalyseur sur la surfaces, par exemple du palladium, réagissant avec le cuivre,
b3) croissance électrolytique de la barrière de diffusion (10, 110) sur une épaisseur donnée.

**10.** Procédé d'assemblage par collage direct selon l'une des revendications 1 à 9, dans lequel l'alliage de la barrière de diffusion (10, 110) est du CoWB, CoWP ou du CoWBP.

**11.** Procédé d'assemblage par collage direct selon l'une des revendications 1 à 8, dans lequel l'étape B) comporte les étapes :

b1') nettoyage des surfaces des éléments et un retrait de l'oxyde natif de cuivre,
b2') croissance de ladite barrière de diffusion (10, 110) sur les portions de cuivre (6, 106) au moyen d'une solution auto-activée.

**12.** Procédé d'assemblage par collage direct selon l'une des revendications 1 à 11, les éléments (1') comportant un substrat (2), une couche de matériau diélectrique (4) déposée sur le substrat (2), ladite couche en matériau diélectrique (4) étant munie de gravures, une couche de cuivre (12) recouvrant la couche en matériau diélectrique (4) et

remplissant les gravures de la couche en matériau diélectrique (4), dans lequel l'étape A) comporte les sous étapes suivantes :

a1) polissage mécano-chimique de la couche de cuivre (12) de chaque élément avec une solution chimique aplanissante jusqu'à obtention d'une surface de cuivre sensiblement plane,
a2) polissage mécano-chimique de la couche de cuivre restante avec une solution chimique non aplanissante sélective jusqu'à retrait total du cuivre sur la couche en matériau diélectrique (4) en dehors de gravures.

**13.** Procédé d'assemblage par collage direct selon la revendication 12, dans lequel les éléments comportent une autre barrière de diffusion (8) entre la couche en matériau diélectrique (4) et la couche de cuivre (12) et dans lequel, lors de l'étape a2), le polissage de la couche de cuivre (12) a lieu jusqu'à sa disparition sur l'autre barrière de diffusion (8) en dehors des gravures.

**14.** Procédé d'assemblage par collage direct selon l'une des revendications 1 à 13, le cuivre (6) étant en retrait de la surface du matériau diélectrique (4).

**15.** Procédé d'assemblage par collage direct selon la revendication 14 en combinaison avec l'une des revendications 9, 10 ou 11, dans lequel la croissance de la barrière de diffusion (10) est stoppée lorsque son épaisseur est au plus égale à la distance entre la surface de la couche en matériau diélectrique (4) et la surface de cuivre en retrait.

**Patentansprüche**

**1.** Verfahren zum Verbinden eines ersten (I) und eines zweiten (II) Elements durch direktes Verkleben, die jeweils mit einer Fläche versehen sind, die durch zumindest ein dielektrisches Material (4, 104) getrennte Kupferabschnitte (6, 106) aufweist, wobei das Verfahren umfasst:

A) zumindest einen Schritt des Polierens der Flächen des ersten und des zweiten Elements, so dass die zu verbindenden Flächen hinsichtlich Rautiefe und Hydrophilie mit einer Verklebung kompatibel sind,
B) einen Schritt des Ausbildens einer Diffusionssperre (10, 110) selektiv an den Kupferabschnitten (6, 106) des ersten und des zweiten Elements, so dass die Fläche der Diffusionssperre des ersten und des zweiten Elements mit der restlichen, zu verbindenden Fläche mit einer Abweichung von unter 5 Nanometer bündig ist, wobei die Diffusionssperre eine Kobalt- oder Nickellegierung ist,
C) einen Schritt des Inkontaktbringens der beiden Flächen, so dass die Kupferabschnitte (6, 106) einer Fläche zumindest teilweise die Kupferabschnitte (106, 6) der anderen Fläche überdecken, wodurch Überdeckungsbereiche gebildet werden, und so dass ein direktes Verkleben zwischen den Flächen in Höhe der dielektrischen Bereiche und in Höhe der Kupferbereiche erhalten wird.

**2.** Verfahren zum Verbinden durch direktes Verkleben nach Anspruch 1, wobei der Schritt B) des Ausbildens einer Diffusionssperre (110, 110) selektiv an den Kupferabschnitten so erfolgt, dass keine Vergrößerung der Rautiefe der zu verbindenden freien Fläche hervorgerufen wird.

**3.** Verfahren zum Verbinden durch direktes Verkleben nach Anspruch 2, wobei der Schritt (A) umfasst:

a) zumindest einen Schritt des Polierens der Flächen, so dass eine Rautiefe von unter 1 nm RMS erhalten wird, und der hydrophilen Flächen,
b) zumindest einen Schritt des Reinigens der Flächen, um aufgrund des Polierens vorhandene Partikel und den Großteil der Korrosionshemmer zu entfernen.

**4.** Verfahren zum Verbinden durch direktes Verkleben nach einem der Ansprüche 1 bis 3, wobei der Schritt C) vor dem Inkontaktbringen der Flächen einen Schritt des Reaktivierens der Flächen umfasst, so dass sie einen hydrophilen Charakter aufweisen.

**5.** Verfahren zum Verbinden durch direktes Verkleben nach einem der Ansprüche 1 bis 4, wobei das Inkontaktbringen aus Schritt C) bei Raumtemperatur und bei Atmosphärendruck erfolgt.

**6.** Verfahren zum Verbinden durch direktes Verkleben nach Anspruch 5, wobei das direkte Verkleben aus Schritt C) zwischen den Kupferabschnitten in Höhe der Überdeckungsbereiche bei Raumtemperatur und bei Atmosphärendruck erfolgt.

**7.** Verfahren zum Verbinden durch direktes Verkleben nach einem der Ansprüche 1 bis 5, wobei das direkte Verkleben in Höhe der Überdeckungsbereiche zwischen den Kupferabschnitten nach einer Wärmebehandlung erhalten wird.

**8.** Verfahren zum Verbinden durch direktes Verkleben nach einem der Ansprüche 1 bis 7 in Kombination mit Anspruch 4, wobei das Reaktivieren der Flächen durch Plasma, beispielsweise He-/$H_2$- oder $N_2/H_2$- oder $O_2/H_2$-Plamsa erhalten wird.

**9.** Verfahren zum Verbinden durch direktes Verkleben nach einem der Ansprüche 1 bis 8, wobei der Schritt B) nachstehende Schritte umfasst:

b1) Reinigen der Flächen der Elemente und Entfernen von nativem Kupferoxid,
b2) Aufbringen eines Katalysators auf die Fläche, beispielsweise Palladium, das mit dem Kupfer reagiert,
b3) elektrolytisches Aufwachsen der Diffusionssperre (10, 110) auf eine vorgegebene Dicke.

**10.** Verfahren zum Verbinden durch direktes Verkleben nach einem der Ansprüche 1 bis 9, wobei die Legierung der Diffusionssperre (10, 110) CoWB, CoWP oder CoWBP ist.

**11.** Verfahren zum Verbinden durch direktes Verkleben nach einem der Ansprüche 1 bis 8, wobei der Schritt B) nachstehende Schritte umfasst:

b1') Reinigen der Flächen der Elemente und Entfernen von nativem Kupferoxid,
b2') Aufwachsen der Diffusionssperre (10, 110) an den Kupferabschnitten (6, 106) mittels einer selbstaktivierenden Lösung.

**12.** Verfahren zum Verbinden durch direktes Verkleben nach einem der Ansprüche 1 bis 11, wobei die Elemente (I') ein Substrat (2), eine Schicht aus dielektrischem Material (4), die auf das Substrat (2) aufgebracht ist, wobei die Schicht aus dielektrischem Material (4) mit Gravierungen versehen ist, und eine Kupferschicht (12), die die Schicht aus dielektrischem Material (4) überdeckt und die Gravierungen der Schicht aus dielektrischem Material (4) ausfüllt, enthalten, wobei der Schritt A) nachstehende Unterschritte umfasst:

a1) mechanisch-chemisches Polieren der Kupferschicht (12) eines jeden Elements mit einer glättenden, chemischen Lösung bis zum Erhalt einer im Wesentlichen ebenen Kupferfläche,
a2) mechanisch-chemisches Polieren der restlichen Kupferschicht mit einer nicht glättenden, chemischen selektiven Lösung bis zum vollständigen Entfernen des Kupfers auf der Schicht aus dielektrischem Material (4) aus den Gravierungen heraus.

**13.** Verfahren zum Verbinden durch direktes Verkleben nach Anspruch 12, wobei die Elemente eine weitere Diffusionssperre (8) zwischen der Schicht aus dielektrischem Material (4) und der Kupferschicht (12) enthalten und wobei in Schritt a2) das Polieren der Kupferschicht (12) bis zu deren Entschwinden an der weiteren Diffusionssperre (8) aus den Gravierungen heraus erfolgt.

**14.** Verfahren zum Verbinden durch direktes Verkleben nach einem der Ansprüche 1 bis 13, wobei das Kupfer (6) von der Fläche des dielektrischen Materials (4) zurückgesetzt ist.

**15.** Verfahren zum Verbinden durch direktes Verkleben nach Anspruch 14 in Kombination mit einem der Ansprüche 9, 10 oder 11, wobei das Aufwachsen der Diffusionssperre (10) angehalten wird, wenn deren Dicke höchstens gleich dem Abstand zwischen der Fläche der Schicht aus dielektrischem Material (4) und der zurückgesetzten Kupferfläche ist.

## Claims

**1.** A process of assembly by direct bonding of a first (I) and of a second (II) element, each having a surface comprising copper portions (6, 106) separated by at least one dielectric material (4, 104), said process comprising:

A) at least one step of polishing of said surfaces of the first and second elements, such that the surfaces to be

assembled are compatible with assembly by bonding, in terms of roughness and hydrophilicity,
B) a step of formation of a diffusion barrier (10, 110) selectively on the copper portions (6, 106) of the first and second elements, such that the surface of the diffusion barrier of the first and second elements is level with the remainder of the surface to be assembled, to within less than 5 nanometres, the diffusion barrier being a cobalt or nickel alloy, and
C) a step of bringing the two surfaces into contact, such that the copper portions (6, 106) of one surface cover at least partly the copper portions (106, 6) of the other surface, forming overlapping areas, and such that direct bonding is obtained between the surfaces at the level of dielectric areas and at the level of copper portions.

**2.** A process of assembly by direct bonding according to claim 1, in which said step B) of formation of a diffusion barrier (10, 110)selectively on the copper portions is executed so that to not cause an increase of roughness of the exposed surface to be assembled

**3.** A process of assembly by direct bonding according to claim 1 or 2, in which said step A) comprises:

a) at least one step of polishing the surfaces so as to obtain a roughness of less than 1 nm RMS, and hydrophilic surfaces,
b) at least one step of cleaning said surfaces in order to eliminate the presence of particles due to the polishing, and most of the corrosion inhibitors.

**4.** A process of assembly by direct bonding according to any one of claim 1 to 3, in which step C) comprises, before the surfaces are brought into contact, a step of reactivation of the surfaces, such that they are hydrophilic.

**5.** A process of assembly by direct bonding according to either of claims 1 or 4, in which the action of bringing the surfaces into contact of step C) takes place at ambient temperature and at ambient pressure.

**6.** A process of assembly by direct bonding according to claim 5, in which the direct bonding of step C) between the copper portions in the overlapping areas takes place at ambient temperature and at atmospheric pressure.

**7.** A process of assembly by direct bonding according to one of the claims 1 to 5, in which the direct bonding in the overlapping areas between the copper portions is obtained after heat treatment.

**8.** A process of assembly by direct bonding according to one of the claims 1 to 7 in combination with claim 4, in which the surfaces are reactivated by plasma, for example $He/H_2$ or $N_2/H_2$ or $O_2/H_2$ plasma.

**9.** A process of assembly by direct bonding according to one of the claims 1 to 87, in which step B) comprises the following steps:

b1) cleaning of the surfaces of the elements and removal of the native copper oxide,
b2) deposition of a catalyst on the surfaces, for example palladium, which reacts with the copper,
b3) electrolytic growth of the diffusion barrier (10, 110) over a given thickness.

**10.** A process of assembly by direct bonding according to one of the claims 1 to 9, in which the alloy of the diffusion barrier (10, 110) is CoWB, CoWP or CoWBP.

**11.** A process of assembly by direct bonding according to one of the claims 1 to 8, in which step B) comprises the following steps:

b1') cleaning of the surfaces of the elements and removal of the native copper oxide,
b2') growth of said diffusion barrier (10, 110) in the copper portions (6, 106) by means of a self-activated solution.

**12.** A process of assembly by direct bonding according to one of the claims 1 to 11, the elements (I') comprising a substrate (2), a layer of dielectric material (4) deposited on the substrate (2), said layer of dielectric material (4) having etchings, and a copper layer (12) covering the layer of dielectric material (4) and filling the etchings of the layer of dielectric material (4), in which step A) comprising the following sub-steps:

a1) chemical mechanical polishing of the copper layer (12) of each element with a levelling chemical solution, until a roughly level copper surface is obtained,

a2) chemical mechanical polishing of the remaining copper layer with a selective non-levelling chemical solution until all the copper on the layer of dielectric material (4) outside the etchings has been removed.

**13.** A process of assembly by direct bonding according to claim 12, in which the elements comprise another diffusion barrier (8) between the layer of dielectric material (4) and the copper layer (12), and in which, in step a2), the copper layer (12) is polished until it disappears in the other diffusion barrier (8) outside the etchings.

**14.** A process of assembly by direct bonding according to one of the claims 1 to 13, where the copper (6) is recessed from the surface of the dielectric material (4).

**15.** A process of assembly by direct bonding according to claim 14 in combination with one of the claims 9, 10 or 11, in which the growth of the diffusion barrier (10) is stopped when its thickness is at most equal to the distance between the surface of the layer of dielectric material (4) and the recessed copper surface.

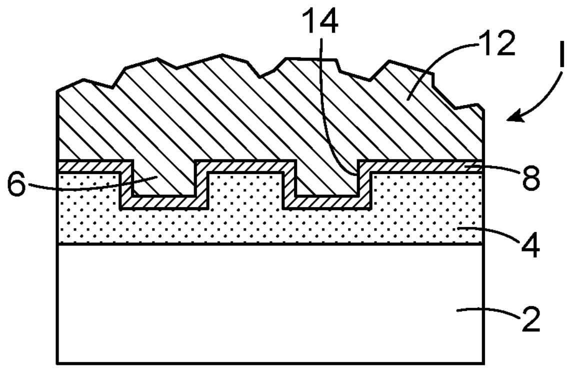

FIG.1A

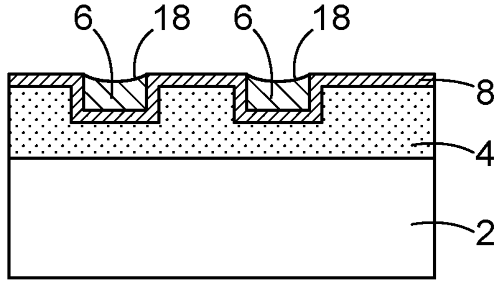

FIG.1B

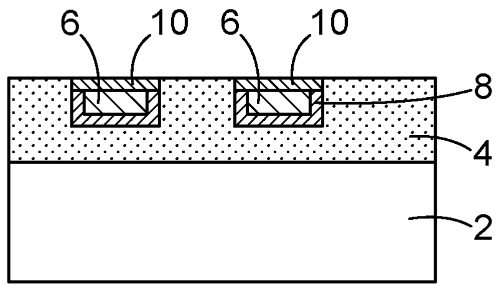

FIG.1C

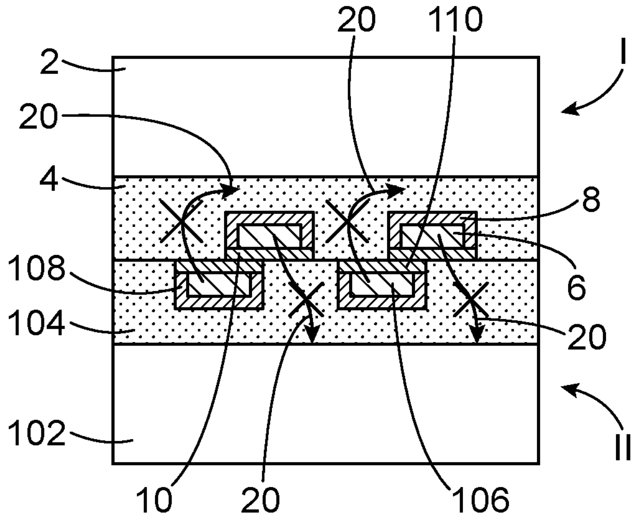

FIG.1D

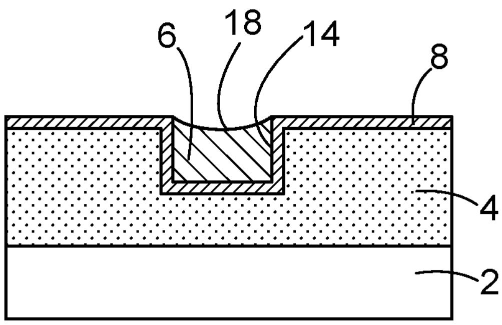

FIG.2A

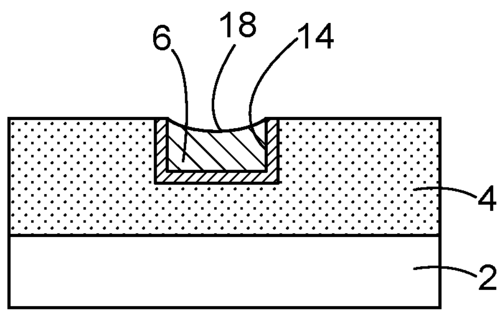

FIG.2B

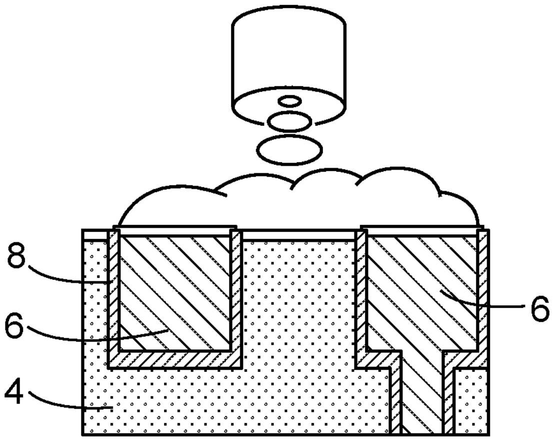


FIG.3A

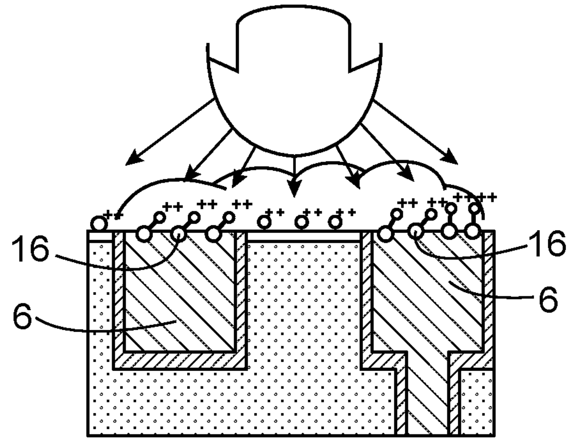


FIG.3B

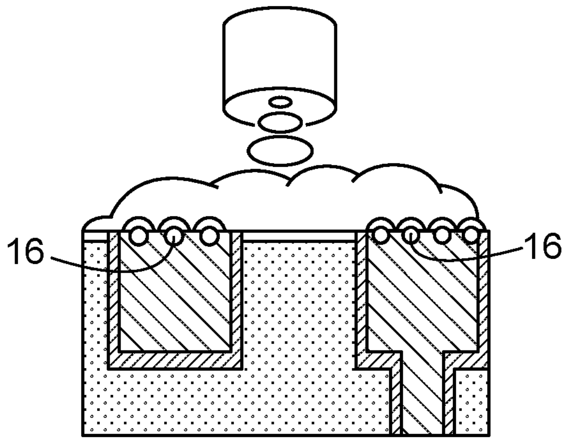


FIG.3C

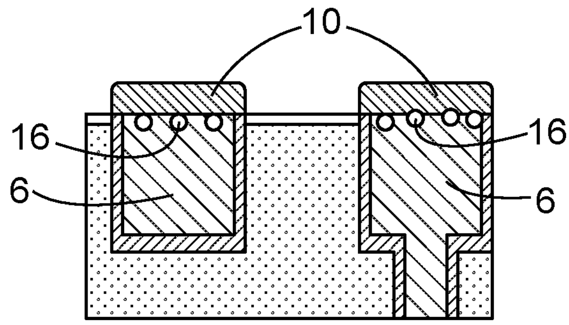


FIG.3D

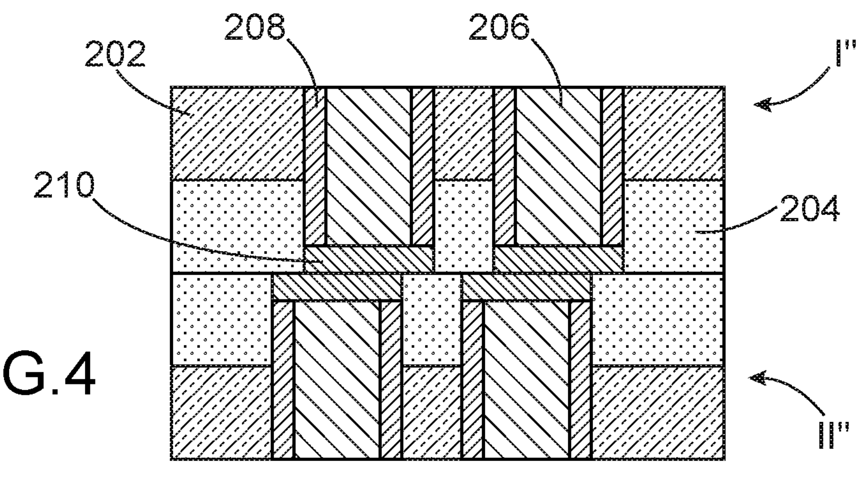


FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2004262772 A
- EP 0700088 A